# EUROPÄISCHE PATENTSCHRIFT

(11) **EP 1 317 990 B1**
(45) Veröffentlichungstag und Bekanntmachung des Hinweises auf die Patenterteilung: **28.09.2005**
(21) Anmeldenummer: 02026722.5
(22) Anmeldetag: 30.11.2002
(51) Int. Cl.: B23K 20/10, B06B 1/06

(54) **Kreuztransducer**
Cross transducer
Transducteur en croix

(30) Priorität: 07.12.2001 DE 10160228
(43) Veröffentlichungstag der Anmeldung: 11.06.2003
(73) Patentinhaber: Hesse & Knipps GmbH, 33100 Paderborn (DE)
(72) Erfinder: Wallaschek, Jörg, Prof. Dr.-Ing., 33102 Paderborn (DE); Vasiljev, Piotr, Prof. Dr., 33100 Paderborn (DE); Hesse, Hans, Dr.-Ing., 33106 Paderborn (DE)
(74) Vertreter: COHAUSZ DAWIDOWICZ HANNIG & SOZIEN

(56) Entgegenhaltungen:
- US-A- 4 854 494
- US-A- 5 595 328
- US-A- 5 697 545
- TSUJINO J ET AL: "High frequency longitudinal-transverse complex vibration systems for ultrasonic wire bonding" ULTRASONICS SYMPOSIUM, 1997. PROCEEDINGS., 1997 IEEE TORONTO, ONT., CANADA 5-8 OCT. 1997, NEW YORK, NY, USA,IEEE, US, 5. Oktober 1997 (1997-10-05), Seiten 849-854, XP010271427 ISBN: 0-7803-4153-8
- TSUJINO J.: 'Recent Developments of Ultrasonic Welding' ULTRASONICS SYMPOSIUM PROCEEDINGS Nr. 2, 07 November 1995 - 10 November 1995, SEATTLE, Seiten 1051 - 1050

## Beschreibung

Die Erfindung betrifft einen Ultraschalltransducer mit wenigstens zwei Ultraschallerzeugern, und einem Ultraschall leitenden Element, an dem ein Werkzeug befestigbar ist. Die Erfindung betrifft weiterhin ein Verfahren zum Betrieb eines Ultraschalltransducers.

Einzelne Ultraschalltransducer sind z.B. aus der US 5 603 445 bekannt. Ein solcher Transducer wird beispielsweise eingesetzt, um mittels Ultraschallenergie Verbindungen zwischen Halbleiterelementen und Substraten herzustellen. Um diese sogenannten Bondverbindungen herzustellen wird mittels eines Ultraschallerzeugers Ultraschall erzeugt, der in ein Ende eines Ultraschall leitenden Elementes eingekoppelt und so zu einem Werkzeug am anderen Ende des Elementes geleitet wird.

Über das derart in Schwingung versetzte Werkzeug kann beispielsweise eine kalte Schweissverbindung zwischen einem Draht und einem Substrat oder Halbleiterchip hergestellt werden.

Als nachteilig wird es empfunden, dass ein solches bekanntes Ultraschallhorn mittels des Ultraschallerzeugers, bei dem es sich üblicherweise um ein Piezoelement oder einen Stapel von Piezoelementen handelt, nur in eine Longitudinalschwingung versetzt werden kann.

Da ein solcher mit einem üblichen Ultraschallhorn aufgebauter Ultraschalltransducer weiterhin an einem Ende an einer Vorrichtung oder an der Maschine befestigt und das andere, das Werkzeug tragende Ende frei ist, muss dieses freie Ende grundsätzlich einen Schwingungsbauch der Longitudinalschwingung darstellen, so dass die Schwingung des Werkzeuges maximal und somit ein optimaler Energietransfer möglich ist.

Aufgrund dieser Tatsache ist die Art der Schwingung des Werkzeuges vorherbestimmt und nicht variabel. Das Werkzeug wird im wesentlichen eine insbesondere eindimensionale Translationsschwingung beschreiben, wie es die Figur 1 der genannten US 5 603 445 zeigt. Z.B. eine Drahtverbindung wird dementsprechend hauptsächlich durch die Reibbewegung des Werkzeuges hergestellt.

Weiterhin ist es nachteilig, dass die Andruckkraft über die Verbindungsstelle zwischen Ultraschalltransducer und Maschine zum Werkzeug geführt werden muss. An dieser Verbindungsstelle befindet sich auch das eigentliche empfindliche die Ultraschallschwingung erzeugende System. Die Andruckkräfte können daher auch zu einer Verstimmung des gesamten Schwingungssystems führen, was sich bei hochpräzisen Bondverbindungen als nachteilig erweist.

Aus der Veröffentlichung von Jiromaru Tsujino und Hiroyuki Yoshihara in IEEE International Ultrasonics Symposium, October 5-8, 1998, Metropolitan Hotel, Sendai Japan ist eine Anordnung zum Ultraschallbonden bekannt, bei der zwei longitudinal schwingende Ultraschallsysteme unter 90 Grad zueinander angeordnet sind, wobei sich ein Ultraschallwerkzeug senkrecht zu beiden Schwingungssystemen erstreckt. Es ist beschrieben, dass mit diesem System eine Bewegung der Werkzeugspitze zweidimensional in einer Ebene parallel zum Substrat und somit auch parellel zur Ebene, in der die Ultraschallerzeuger angeordnet sind, erzeugt werden kann. Eine Bewegung in der Höhe gegenüber dem Substrat ist hier nicht beschrieben.

Die weitere Veröffentlichung von Jiromaru Tsujino in IEEE Ultrasonics Symposium, 1995, "Recent Developments of Ultrasonic Welding", Seiten 1051ff offenbart mehrere longitudinal schwingende Ultraschallsysteme die in einer Ebene angeordnet sind und von denen je zwei einander unter 180 Grad gegenüberliegen, wobei sich ein Ultraschallwerkzeug senkrecht zu diesen Schwingungssystemen erstreckt

Aufgabe der Erfindung ist es, einen Ultraschalltransducer, bzw ein Ultraschall leitendes Element zur Verfügung zu stellen, mit dem auf einfache Weise eine variable Schwingungsform eines Werkzeuges einstellbar ist, insbesondere auch eine zwei- oder dreidimensionale Bewegung, wobei eine Schwingungsrichtung senkrecht zu einem Substrat liegt und wobei weiterhin eine einfache Montage und Krafteinleitung ermöglicht wird.

Diese Aufgabe wird gemäß der Erfindung dadurch gelöst, dass das Ultraschall leitende Element wenigstens drei sich von einer gemeinsamen Verbindungsstelle erstreckende Arme aufweist; wobei ein das Werkzeug (6) tragender Arm (2c) zu einem einen Ultraschallerzeuger (4) tragenden Arm (2a, 2d) unter 180 Grad orientiert ist und ein oder mehrere weitere Arme vorgesehen sind, die einen Ultraschallerzeuger tragen und je unter 90 Grad zu dem Arm orientiert sind, der das Werkzeug trägt.

Hierbei kann der das Werkzeug tragende Arm in der praktischen Ausführung auch sehr kurz bzw. im Grenzwert mit der Länge Null ausgebildet sein, so dass dann das Werkzeug selbst diesen Arm bildet.

Durch diese Ausführung kann das Werkzeug besonders einfach dreidimensional im Raum bewegt werden.

Mittels dieses Ultraschallerzeugers wird in diesen beiden Armen eine stehende Longitudinalwelle erzeugt, die das Werkzeug zu einer Auf- und Abbewegung, bzw. Vor- und Zurückbewegung veranlasst, und zwar aufgrund des Superpositiponsprinzipes unabhängig von evtl. weiteren Schwingungen senkrecht oder in einem anderen Winkel hierzu. Es besteht also die Möglichkeit auch ein "Hammering"-Bonden mit dem so angetriebenen Werkzeug auszuführen.

Wird nun noch ebenfalls wenigstens ein Ultraschallerzeuger angesteuert, der auf wenigstens einem hierzu senkrecht angeordneten Arm sitzt, so kann je nach Phasenlage an der Verbindungstelle die Longitudinalschwingung des Werkzeuges verstärkt, abgeschwächt oder mit einer Transversalbewegung überlagert werden.

Dies ist wiederum besonders einfach möglich, wenn senkrecht um die sich ausbreitende Longitudinalwelle, die das Werkzeug hammernd antreibt mehrere Ultraschallerzeuger auf mehreren Armen in einer Ebene angeordnet sind, die mit gewünschter Phase und/oder Frequenz angesteuert werden. Bei dieser Anordnung können mit dem Werkzeug z.B. Ellipsen gefahren und gleichzeitig gehammert werden.

Eine ebenfalls sehr vorteilhafte Konstruktion ergibt sich, wenn an zwei zueinander unter 90 Grad und/oder 180 Grad orientierten Armen Ultraschallerzeuger angeordnet sind, wobei der das Werkzeug tragende Arm zu einem der einen Ultraschallerzeuger tragenden Arme unter 180 Grad orientiert ist. Diese Konstruktion kann sowohl bei einer T-Form oder Kreuzform oder auch Doppelkreuzform, Sternform oder Unterformen vorgesehen sein.

Insbesondere ist unter einer Orientierung von 180 Grad zueinander zu verstehen, dass die Arme bzw. die darauf angeordneten Ultraschallerzeuger auf einer gemeinsamen Achse liegen, so dass die erzeugten Ultraschallwellen zentrisch aufeinander zulaufen. Hierdurch kann verhindert werden, dass bei einer evtl. azentrischen Einwirkung der Ultraschallwellen auf den dritten Arm dieser eine Torsionsschwingung um seine Längsachse ausführt.

Z.B. kann der Arm, an dem sich das Werkzeug befindet in einem Winkel unter 90 Grad zu weiteren Armen orientiert sein, die Ultraschallerzeuger tragen, so dass sich die am Ultraschallerzeuger entstandene Schwingung zunächst als Longitudinalwelle ausbreitet, sich dann aber je nach Phasenlage an der gemeinsamen Verbindungsstelle aufgrund der Kontinuitätsbedingung in Mischformen oder auch reine Formen von Longitudinalwelle und Transversalwelle wandelt, die sich in den Arm ausbreitet, an dem das Werkzeug befestigt ist, wobei sich das Werkzeug bevorzugt in einer axialen Richtung des Werkzeugarmes erstreckt und somit quasi dessen Verlängerung darstellt.

Hierbei können die Arme, z.B. durch Längenauswahl zur Abstimmung des gesammten schwingenden Systems eingesetzt werden. Durch die gegenüberliegenden Ultraschallerzeuger kann besonders einfach eine resonante stehende Welle in den beiden Armen zwischen diesen Ultraschallerzeugern eingestellt werden, wobei es durch entsprechende Ansteuerung (z.B. Verschiebung der Phase und/oder Änderung der Frequenz) möglich ist, an der Verbindungstelle der Arme einen longitudinalen Schwingungsknoten oder einen Schwingungsbauch bzw. beliebige andere Phasenlagen der stehenden Welle zwischen diesem beiden Extrema einzustellen.

Wird an der Verbindungsstelle z.B. ein Schwingungsbauch der longitudinalen erzeugten Welle eingestellt, so wird das Werkzeug an dem senkrecht hierzu angeordneten Arm sich transversal, also seitlich bewegen. Dementsprechend kann mit dem Werkzeug eine Reibverschweissung wie beim klassischen Transversal-Bonden hergestellt werden.

Wird ein Schwingungsknoten an der Verbindungsstelle eingestellt, so wird das Werkzeug sich longitudinal, also vor und zurück (mit Bezug auf ein Substrat) bewegen. Man spricht sodann vom sogenannten Hammering-Bonden.

Entsprechende Mischformen ergeben sich zwischen diesen Extrema. Mit dieser Ausführung kann eine Werkzeugspitze zumindest zweidimensional bewegt werden, wobei eine Schwingungsrichtung senkrecht zu einem zu bondenden Substrat orientiert ist. Ein Bondprozess kann so gezielt durch zeitliche Änderung der Phasenlage oder Änderung der Frequenz kontrolliert werden, so dass während eines Bondvorganges auch zwischen verschiedenen Schwingungsformen gewechselt werden kann.

In welcher Phasenlage für die Einstellung der Knoten oder Bäuche an der Verbindungsstelle die Ultraschallerzeuger anzusteuern sind (z.B. gleich- oder gegenphasig) ergibt sich im wesentlichen aus den Längenverhältnissen der Arme, die die Schwingungserzeuger tragen. Die Anpassung der Längen und der Betriebsfrequenz der Ultraschallerzeuger erlaubt weiterhin resonanten Betrieb für maximalen Energieübertrag.

Ebenfalls kann es vorgesehen sein, verschiedene Ultraschallerzeuger mit unterschiedlichen Frequenzen, insbesondere mit jeweiligen Vielfachen zu betreiben, und dabei die Phasenlage an der Verbindungsstelle gezielt zu beeinflussen. Dies ermöglicht auch höhere Ordnungen der erzeugten Schwingungen der Werkzeugspitze.

Bei einem erfindungsgemäßen Transducer bzw. Ultraschall leitenden Element, bei dem je zwei Arme mit Ultraschallerzeugern, die unter 180 Grad zueinander orientiert sind, ein Armpaar bilden, können auch mehrere solcher Armpaare vorgesehen sein, die in jeder beliebigen Orientierung zueinander angeordnet sind, so dass sich je nach Konstruktion und Ansteuerung die Möglichkeit ergibt, eine reine longitudinale, insbesondere stehende Welle in Mischformen oder eine reine transversale Welle zu wandeln. Bei zwei Armpaaren (4 Schallerzeugern) sind die Arme bevorzugt unter 90 Grad, bei 3 Paaren unter 60 Grad etc., innerhalb einer Ebene, angeordnet.

Beispielsweise können in einer Ebene wenigstens zwei, bevorzugt vier Arme mit Ultraschallerzeugern vorgesehen sein, die z.B. jeweils unter 90 Grad zueinander angeordnet sind. Die z.B. bei vier Ultraschallerzeugern einander gegenüberliegenden Ultraschallerzeuger können bevorzugt elektrisch zusammengeschaltet sein, so dass sich im wesentlichen zwei zueinander orthogonale Schwingungssysteme ergeben, die in einer Ebene liegen. Senkrecht zu dieser Ebene kann ein Arm mit einer Werkzeugaufnahme vorgesehen sein, der z.B. an der gemeinsamen Verbindungsstelle der Schwingungsarme angeordnet ist. Durch geeignete Ansteuerung kann dann die Werkzeugspitze beliebige Schwingungsformen in einer Ebene oder auch Schwingungen ausserhalb der Ebene beschreiben, je nach Phasenlage an der Verbindungsstelle.

Hierbei kann insbesondere durch die Kreuzung aller Arme in einer gemeinsamen Verbindungsstelle die Krafteinleitung zum Bonden über diese Verbindungsstelle erfolgen, so dass der Kraftfluss ausserhalb des schwingenden Systemes, bzw, der Schwingungserzeuger liegt.

Das physikalische Prinzip, das dieser Wandlung zugrunde liegt, ist die Tatsache, dass sich bei einer longitudinalen Streckung von Material sich an der Streckstelle eine Verdünnung des Materials einstellt. Umgekehrt verhält es sich bei einer Stauchung. Das Verhältnis von Streckung zu Stauchung wird auch als Poisson-Verhältnis oder Poisson-Zahl bezeichnet.

In einer stehenden Longitudinalwelle innerhalb eines Materials wird sich daher im Schwingungsbauch eine zur Longitudinalwelle senkrechte Transversalwelle und im Knoten eine Longitudinalwelle einstellen. Zwischen diesen Extrema, bzw. unter anderen Winkeln werden sich Mischformen ergeben. Diese Schwingungsformen (Bauch, Knoten, Zwischenformen) können erfindungsgemäß durch entsprechende Ansteuerung in der gemeinsamen Verbindungstelle der Arme eingestellt werden, so dass die resultierende Schwingung in dem sich von der Verbindungsstelle erstreckenden Werkzeug-Arm kontrollierbar ist.

Das erfindungsgemäße Ultraschall leitende Element ist demnach geeignet die erzeugte Longitudinalschwingung zu wandeln und somit das Werkzeug mit beliebigen auch einstellbaren Schwingungsformen zu beaufschlagen.

Eine besonders einfache konstruktive Ausgestaltung ergibt sich dadurch, dass die Arme des Ultraschall leitenden Elementes zueinander unter 90 und/oder 180 Grad angeordnet sind, so dass das Ultraschall leitende Element T-förmig, kreuzförmig oder doppelkreuzförmig oder als Teil dieser Formen ausgebildet ist. Die Kreuzform kann durch mehr als 4 Arme auch als Sternform ausgebildet werden. Unter der Doppelkreuzform wird die Form verstanden, bei der ausgehend von der Kreuzform senkrecht zu den 4 in einer Ebene liegenden Armen noch zwei weitere Arme an der Verbindungsstelle angeordnet sind. Auch hier kann eine dreidimensionale Sternform durch Hinzufügung weiterer Arme erfolgen.

Unterformen zu den vorgenannten Formen können gebildet werden, indem ausgehend von der symmetrischen Grundform (T, Kreuz, Doppelkreuz, Stern) ein oder mehrere Arme in Entfall kommen.

Die vorgenannte Ausführung entspricht im wesentlichen der T-Form.

Eine weitere Ausführung ergibt sich, wenn z.B. eine Kreuzform des Ultraschall leitenden Elementes gewählt wird. In diesem Fall kann durch einen Arm, der dem Werkzeug-Arm unter 180 Grad gegenüberliegt eine weitere bessere Abstimmung der gewandelten Schwingung/Welle erfolgen. Dieser Arm trägt wie später beschrieben ist, auch einen Ultraschallerzeuger tragen.

Eine bevorzugte Ausbildung dieser Konstruktion ist darin gegeben, dass an allen in einer Ebene liegenden Armen, bis auf den, der das Werkzeug trägt, Ultraschallerzeuger angeordnet sind. Dies kann z.B. bei einer Kreuzform, Doppelkreuzform oder dreidimensionalen Sternform bzw. Unterformen des

Ultraschall leitenden Elementes vorgesehen sein.

Ein weiterer für sich stehender Vorteil der erfindungsgemäßen Konstruktionen ergibt sich, wenn der Arm, der zu dem das Werkzeug tragenden Arm unter 180 Grad orientiert ist, ein elastisches Element, insbesondere ein Federelement aufweist. Mittels diesem Federelement kann eine Anpresskraft in den Ultraschalltransducer eingeleitet werden, durch die das Werkzeug auf ein Werkstück pressbar ist. Die Krafteinleitung kann aber auch auf beliebige andere Weise, z.B. berührungslos mittels elektromagnetischer Felder erfolgen.

Die Anpresskraft liegt hier und bevorzugt bei allen anderen Ausführungen in der gleichen Richtung, wie die Längsachse des Armes, der das Werkzeug trägt. Senkrecht zu dieser Achse können gemäß den schon zuvor beschriebenen Ausführungen Ultraschallerzeuger an den übrigen Armen angeordnet sein, so dass diese ausserhalb der wirkenden Kraft liegen. Dies hat den Vorteil, dass die Anpresskraft genau in die Bondstelle einleitbar ist und das ein Teil des schwingungserzeugenden Systems, also z.B. ein Piezosystem nicht im Kraftfluss der Anpresskraft liegt. Somit wird eine Verstimmung des gesamten Systems bei Kraftbeaufschlagung vermieden, zumal es keine Biegebeanspruchung des Transducers gibt.

Auch ist das System bei dieser Anordnung besonders für das Flip-Chip-Bonden geeignet, wo sehr grosse Anpresskräfte benötigt werden.

Der Ultraschalltransducer wird auch dadurch vorteilhaft weitergebildet, dass das Ultraschall leitende Element wenigstens eine Verbindungsstelle aufweist, mittels der das Element an einer Maschine, insbesondere einer Maschine zum Herstellen von Bondverbindungen, befestigbar ist.

Vorteilhaft ist die Auslegung der Geometrie so, dass diese oder jede Verbindungsstelle bei schwingungserregtem Zustand in einem Knotenpunkt der Schwingung liegt. Hierzu kann auch einer oder mehrere der Arme die Verbindungsstelle zur Befestigung an einer Maschine darstellen. Es kann ein Arm gewählt werden, über den eine Krafteinleitung, z.B. über ein elastisches Element erfolgt. Auch kann die Geometrie so gewählt sein, dass am Ort der Einleitung der Anpresskraft ein Schwingungsknoten liegt, damit hier keine Energie verloren geht.

Um weiterhin die Möglichkeit einer Amplitudentransformation zu berücksichtigen kann es vorgesehen sein, dass die einzelnen Arme des Ultraschall leitenden Elementes verschiedene Querschnitte aufweisen können, die auch einen verjüngenden Verlauf haben können.

Eine mehrdimensionale Bewegung einer Werkzeugspitze kann auch, insbesondere in Verbindung mit den vorgenannten Ausführungen, erreicht werden, wenn die einzelnen Keramiken eines Piezostapels ortsabhängig polarisierbar sind, also z.B. rechts- und linksseitig einer Symmetriebene unterschiedlich. Z.B. können bei einer scheibenförmigen Anordnung auch verschiedene Scheibensegmente unterschiedlich polarisierbar sein. Auch hierdurch kann durch die somit erzeugten Kippeffekte eine mehrdimensionale Bewegung des Werkzeuges erreicht werden.

Ausführungsbeispiele der Erfindung sind in den nachfolgenden Figuren dargestellt. Es zeigen:
- Figur 1:: Einen nicht erfindungsgemäßen Ultraschalltransducer in Kreuzform mit zwei Ultraschallerzeugern die unter 180 Grad zueinander orientiert sind und einem Werkzeug;
- Figur 2:: Einen nicht einfindungsgemäßen Ultraschalltransducer mit vier Ultraschallerzeugern in einer Ebene.
- Figur 3:: Einen Ultraschalltransducer in Kreuzform mit zwei Ultraschallerzeugern, die unter 90 Grad zueinander orientiert sind und einem Werkzeug;
- Figur 4:: Einen Ultraschalltransducer mit vier Armen zur Erzeugung einer dreidimensionalen Bewegung des Werkzeuges;

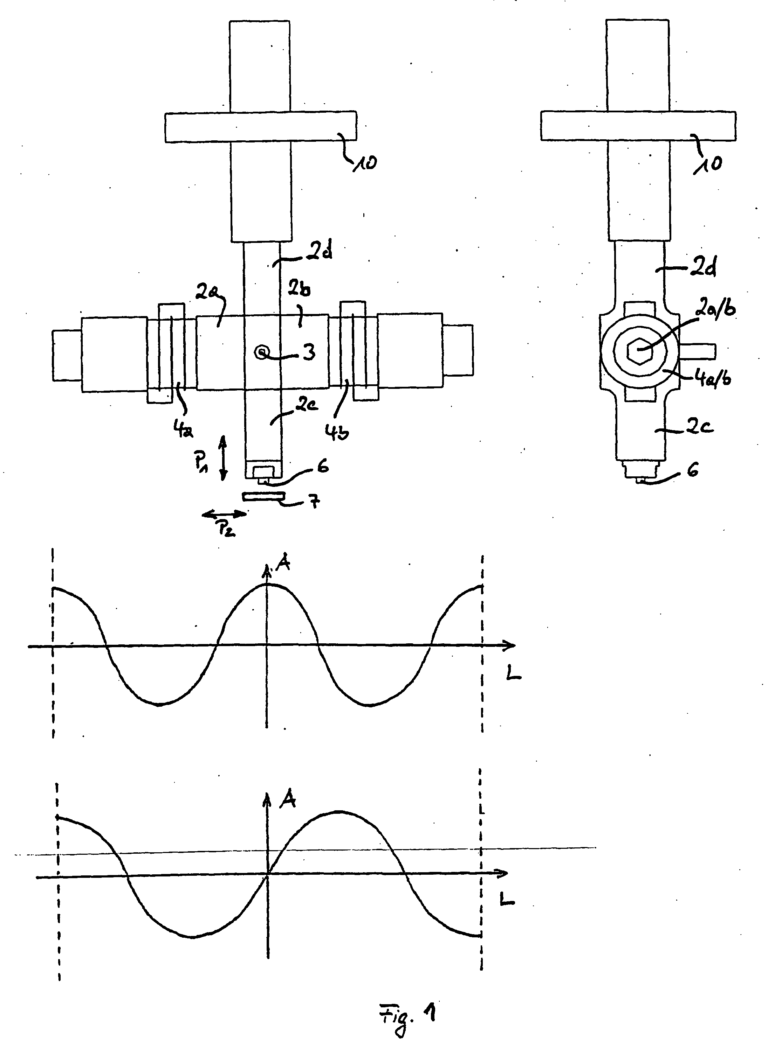

Figur 1 zeigt eine Kreuzkonstruktion eines dem Wesen nach bekannten Transducers mit zwei Ultraschallerzeugern 4a und 4b, die jeweils am Arm 2a bzw. 2b unter 180 Grad zueinander angeordnet sind. In vertikaler Richtung ist der das Werkzeug 6 tragende Arm 2c und z.B. ein zur Abstimmung und/oder Befestigung vorgesehener Arm 2d vorgesehen.

Je nach Phasen- oder Frequenz-Ansteuerung der Piezos 4a und 4b kann es erreicht werden, dass sich an der gemeinsamen Verbindungsstelle 3 bei der longitudinalen Welle in den Armen 2a und 2b ein Wellenberg oder ein Wellenknoten einstellt, so dass sich dementsprechend in dem Arm 2c eine transversale oder longitudinale Welle oder Mischform ausbreitet und das Werkzeug 6 an Ende des Armes 2c in entsprechende Schwingung versetzt, die auf einen Chip 7 übertragen werden kann, um einen Bondvorgang durchzuführen.

Die Ausbildung eines Wellenberges ist in einer Amplitudendarstellung unterhalb der Transducerkonstruktion oben und ein Wellenknoten unten dargestellt.

Bei einem Wellenberg am Ort 3 der gemeinsamen Verbindung wird sich eine transversale also seitliche Bewegung des Werkzeuges 6 entsprechend Pfeil P2 einstellen. Bei einer Ansteuerung, bei der sich ein Schwingungsknoten in der gemeinsamen Verbindungsstelle 3 ergibt, wird sich in den Armen 2c und 2d eine longitudinale stehende Welle einstellen, so dass das Werkzeug 6 eine Auf- und Abbewegung entsprechend dem Pfeil P1 vollzieht und ein sogenanntes Hammering-Bonden des unter dem Werkzeug liegenden Chips 7 möglich ist.

Bei entsprechend hiervon abweichenden Phasenlagen an der Verbindungsstelle 3 erfolgt eine Überlagerung der Bewegungen.

Für eine Verbindung des Transducers 1 mit der nicht gezeigten Bondmaschine, die z.B. ebenfalls in einem Schwingungsknoten erfolgt, ist eine bevorzugt schwingungsentkoppelnde Aufnahme 10 vorgesehen, in die der freie Arm 2d übergeht. Diese z.B. kreisrunde Aufnahme kann über eine Ringklemmung an der Bondmaschine befestigt werden.

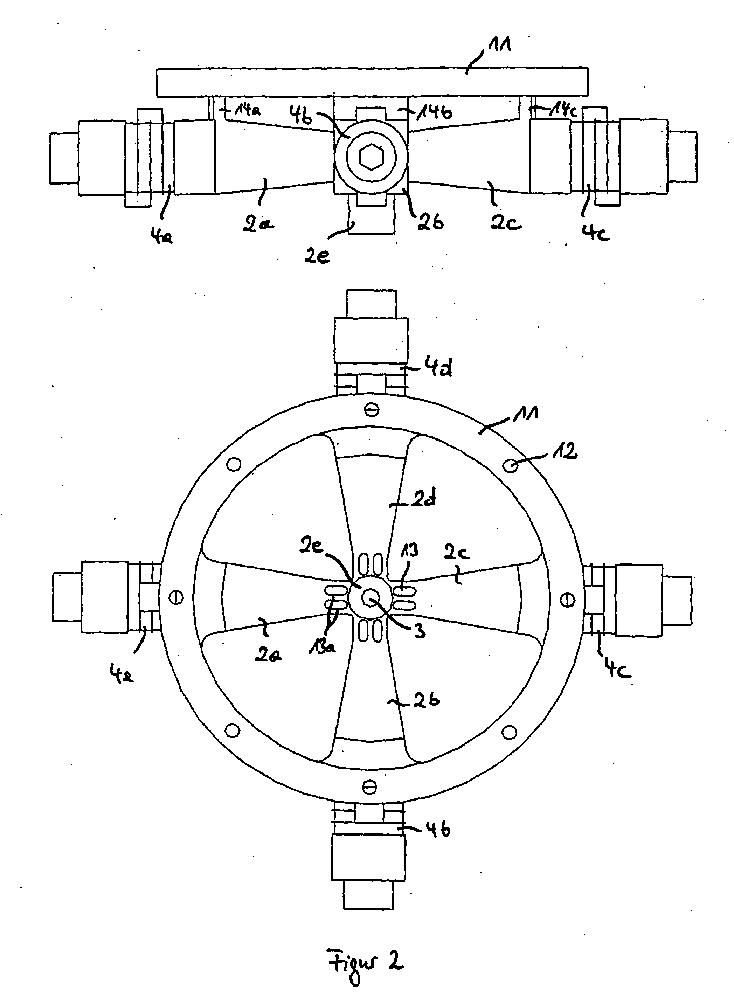

In der Figur 2 ist eine dem Wesen nach ebenso bekannte Anordnung gezeigt, bei der insgesamt in einer Ebene vier Ultraschallerzeuger 4a, 4b, 4c und 4d angeordnet sind, die jeweils an einem Arm 2a, 2b, 2c und 2d in dieser Ebene befestigt sind. Senkrecht zu dieser Ebene, die durch die Arme 2a,b,c,d aufgespannt wird, ist ein Arm 2e angeordnet, der ein nicht gezeigtes Werkzeug tragen kann. Dieses Werkzeug kann durch die vier Ultraschallerzeuger 4a,b,c,d in beliebiger Form innerhalb der Bondebene, die parallel zur Ebene durch die Arme 2a,b,c,d liegt, bewegt werden, z.B. mit Lissajousfiguren. Bei verschiedenen Frequenzen, insbesondere Vielfachen, zur Ansteuerung der Ultraschallerzeuger können auch Lissajous-Figuren höherer Ordnung erzeugt werden.

Um eine Schwingungskonzentration zu erzielen sind die einzelnen Arme 2a,b,c und d in Richtung auf die gemeinsame Verbindungsstelle 3 verjüngend ausgebildet.

Innerhalb eines jeden Armes 2a,b,c,d mit Schwingungserzeugern ist in der Umgebung der Verbindungsstelle 3 wenigstens eine Ausnehmung 13 angeordnet, die für eine Entkopplung zur Armrichtung orthogonaler Schwingungen beiträgt. Im vorliegenden Fall sind pro Arm zwei Ausnehmungen 13 vorgesehen. Hierzu sind die Ausnehmungen 13 in Armrichtung bevorzugt länger als sie quer dazu breit sind. Dies führt dazu, dass sich über die sich ausbildenden Stege 13a in Armrichtung eine Longitudinalwelle aufgrund der Biegesteifigkeit der Stege in dieser Richtung sehr gut, eine Welle senkrecht dazu jedoch nur schlecht ausbreiten kann, da in dieser senkrechten Richtung die Stege als flexibles Festkörpergelenk bzw. Biegeelement wirken.

Jeweils einander unter 180 Grad gegenüberliegende Ultraschallerzeuger 4a,c und 4b,4d können bevorzugt elektrisch zusammengeschaltet sein, d.h. diese wirken als ein Schwingungssystem, so dass hier zwei orthogonale Schwingungssysteme realisiert sein können.

Die einzelnen Arme sind untereinander über einen Ring 11 verbunden, der in einer Ebene parallel zur Ebene der Arme 2a,b,c,d angeordnet ist. Die Verbindung zwischen Ring 11 und jeweils einem Arm 2a,b,c,d erfolgt über je einen Steg 14a,b,c,d, der bevorzugt innerhalb eines Schwingungsknotens in den betreffenden Arm 2a,b,c,d übergeht.

Der Ring 11 ist mit Bohrungen 12 versehen, um diesen an einer Bondmaschine zu befestigen. Gemäß der beanspruchten Erfindung kann es hier vorgesehen sein, dass sich unter 180 Grad zu dem Arm 2e, der das Werkzeug trägt, ein weiterer Arm angeordnet ist, der einen Ultraschallerzeuger trägt.

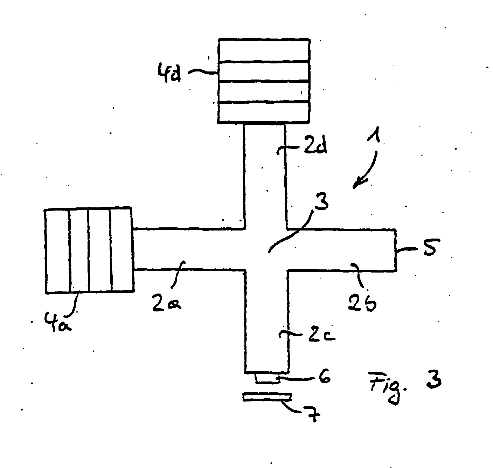

Figur 3 zeigt gemäß dem wesentlichen Anspekt der Erfindung zur Erzielung mehrdimensionaler Bewegung eine Ausführung mit vier Armen, bei der zwei Ultraschallerzeuger 4a und 4d an Armen 2a und 2d unter 90 Grad zueinander vorgesehen sind, wobei einer der Schwingungserzeuger unter 180 Grad zum Werkzeugarm orientiert ist. Der Ultraschallerzeuger 4d wird bei Ansteuerung in den Armen 2d und 2c eine longitudinale Welle erzeugen, die das Werkzeug 6 auf und abschwingen lässt.

Durch Ansteuerung des Ultraschallerzeugers 4a wird sich je nach Phasenlage an der gemeinsamen Verbindungsstelle 3 eine Verstärkung oder Schwächung der Longitudinalschwingung des Werkzeuges 6 ergeben oder aber auch einer Überlagerung mit einer Transversalschwingung. Es lassen sich also auch mit dieser Anordnung so wie schon bei den anderen Ausführungen Auf- und Abschwingungen des Werkzeuges 6 mit Lateralschwingungen überlagern.

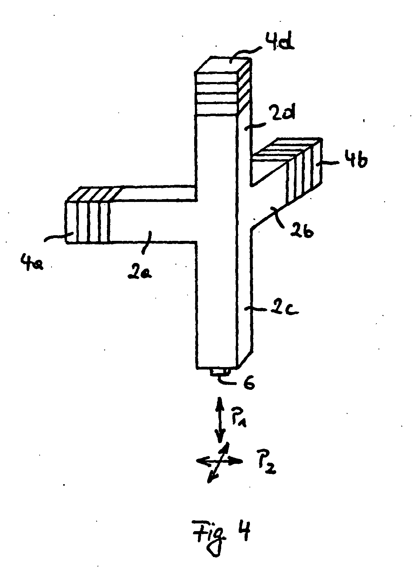

In einer Weiterbildung der Figur 3 könnte am freien Ende 5 des Armes 2b noch ein Ultraschallerzeuger angeordnet sein.Figur 4 zeigt eine weitere Ausführung mit zwei Ultraschallerzeugern 4a und 4b, die in einer Ebene unter 90 Grad Orientierung zueinander angeordnet sind. Ausserhalb der Ebene, die durch die Arme 2a und 2b aufgespannt wird befinden sich je unter 90 Grad zu dieser Ebene ein Arm 2c mit einem Werkzeug 6 und ein weiterer Ultraschallerzeuger 4d. Dieser Ultraschallerzeuger 4d und der Arm 2c mit dem Werkzeug 6 sind unter 180 Grad zueinander orientiert.

Diese Anordnung nach Figur 4 entspricht im wesentlichen der Anordnung nach Figur 3 mit einem zusätzlichen Ultraschallerzeuger 4b im rechten Winkel zum Ultraschallerzeuger 4a.

In beschriebener Weise kann mit dem Ultraschallerzeuger 4d das Werkzeug 6 in eine Auf- und Abschwingung gemäß Pfeil P1 versetzt werden. Durch die weiteren Ultraschallerzeuger 4a und 4b ergibt sich die einfache Möglichkeit zwei weitere laterale zueinander senkrecht stehende Bewegungen P2 des Werkzeuges 6 zu generieren, so dass insgesamt eine beliebige dreidimensionale Steuerung des Werkzeuges 6 ermöglicht wird.

Als insgesamt vorteilhaft stellt sich heraus, dass durch die Aufteilung der gesamten eingeleiteten Ultraschallenergie auf mehrere Raumrichtungen eine geringere Belastung pro Raumrichtung auftritt, so dass hierdurch zum Teil die Bondbarkeit empfindlicher Chips erst ermöglicht wird.

Die dargestellten Ausführungen zeigen eine einfache Möglichkeit ein Werkzeug zum Bonden von Halbleitern, sei es zum Flip-Chip oder Drahtbonden auf verschiedene Weisen mehrdimensional anzutreiben und darüber hinaus eine Krafteinleitung zu realisieren, die nicht mehr zu einer Verstimmung des schwingenden Systems führt.

## Patentansprüche

1. Ultraschalltransducer (1) mit wenigstens zwei Ultraschallerzeugern (4), und einem Ultraschall leitenden Element, an dem ein Werkzeug (6) befestigbar ist, **dadurch gekennzeichnet, dass** das Ultraschall leitende Element wenigstens drei sich von einer gemeinsamen Verbindungsstelle (3) erstreckende Arme (2a,2b,2c...) aufweist, wobei ein das Werkzeug (6) tragender Arm (2c) zu einem einen Ultraschallerzeuger (4) tragenden Arm (2a, 2d) unter 180 Grad orientiert ist und ein oder mehrere weitere Arme vorgesehen sind, die einen Ultraschallerzeuger tragen und je unter 90 Grad zu dem Arm orientiert sind, der das Werkzeug trägt.

2. Ultraschalltransducer nach einem der vorherigen Ansprüche, **dadurch gekennzeichnet, dass** an wenigstens zwei zueinander unter 90 Grad und/oder 180 Grad orientierten Armen (2a, 2b) Ultraschallerzeuger angeordnet sind, wobei der das Werkzeug (6) tragende Arm (2c) zu diesen Armen (2a, 2b) unter 90 Grad orientiert ist.

3. Ultraschalltransducer nach einem der vorherigen Ansprüche, **dadurch gekennzeichnet, dass** die Arme mit Ultraschallerzeugern, die innerhalb einer gemeinsamen Ebene angeordnet sind, untereinander mit einem insbesondere ringförmigen Befestigungselement verbunden sind.

4. Ultraschalltransducer nach einem der vorherigen Ansprüche, **dadurch gekennzeichnet, dass** ein Arm (2d), der zu dem das Werkzeug (6) tragenden Arm (2c) unter 180 Grad orientiert ist, ein elastisches Element (9), insbesondere ein Federelement aufweist, insbesondere mittels dem eine Anpresskraft in den Ultraschalltransducer (1) einleitbar ist, durch die das Werkzeug (6) auf ein Werkstück (7) pressbar ist.

5. Ultraschalltransducer nach einem der vorherigen Ansprüche, **dadurch gekennzeichnet, dass** das Ultraschall leitende Element, insbesondere wenigstens ein Arm, eine Verbindungsstelle aufweist, mittels der das Element an einer Maschine (8), insbesondere einer Maschine zum Herstellen von Bondverbindungen, befestigbar ist.

6. Ultraschalltransducer nach Anspruch 5, **dadurch gekennzeichnet, dass** eine Verbindungsstelle bei schwingungserregtem Zustand in einem Kontenpunkt der Schwingung liegt.

7. Ultraschalltransducer nach einem der vorherigen Ansprüche, **dadurch gekennzeichnet, dass** wenigstens einer der Arme (2d) die Verbindungsstelle zur Befestigung an einer Maschine bildet.

8. Ultraschalltransducer nach einem der vorherigen Ansprüche, **dadurch gekennzeichnet, dass** die Arme (2a,2b,2c,2d,...) verschiedene, insbesondere sich verjüngende Querschnitte aufweisen.

9. Ultraschalltransducer nach einem der vorherigen Ansprüche, **dadurch gekennzeichnet, dass** innerhalb eines Armes (2,a,b,c,d), insbesondere in einer Umgebung der gemeinsamen Verbindungsstelle (3) wenigstens eine Ausnehmung (13) angeordnet ist, insbesondere zur Schwingungsentkopplung in einer Raumrichtung.

10. Verfahren zum Ultraschallbonden, **dadurch gekennzeichnet, dass** ein Ultraschalltransducer nach einem der Ansprüche 1 bis 9 verwendet wird.

## Claims

1. Ultrasound transducer (1) with at least two ultrasound generators (4), and an ultrasound ducting element to which is attached a tool (6), **characterised in that** the ultrasound ducting element comprises at least three arms (2a, 2b, 2c ...) which extend from a common connecting point (3), and an arm (2c) which carries the tool (6) is oriented at 180 degrees towards an arm (2a, 2d) which carries an ultrasound generator (4), and one or more additional arms are provided which carry an ultrasound generator and which are each at 90 degrees oriented towards the arm which carries the tool.

2. Ultrasound transducer according to one of the above claims, **characterised in that** on at least two arms (2a, 2b) which are oriented relative to each other at 90 degrees and/or 180 degrees are arranged ultrasound generators, and the arm (2c) which carries the tool (6) is oriented at 90 degrees relative to these arms (2a, 2b).

3. Ultrasound transducer according to one of the above claims, **characterised in that** the arms with ultrasound generators arranged within a common plane are connected to each other by means of a fixing element, in particular of circular shape.

4. Ultrasound transducer according to one of the above claims, **characterised in that** an arm (2d) which is oriented at 180 degrees towards arm (2c) which carries the tool (6) comprises an elastic element (9), in particular a spring element, in particular by means of which a press-on force is introducible into the ultrasound transducer (1) by means of which the tool (6) can be pressed onto a workpiece.

5. Ultrasound transducer according to one of the above claims, **characterised in that** the ultrasound ducting element, in particular at least one arm, comprises a connecting point by means of which the element can be attached to a machine (8), in particular a machine for producing bonded connections.

6. Ultrasound transducer according to Claim 5, **characterised in that** a connecting point in an oscillation excited state lies in an intersecting point of the oscillation.

7. Ultrasound transducer according to one of the above claims, **characterised in that** at least one of the arms (2d) establishes the connecting point for attachment on a machine.

8. Ultrasound transducer according to one of the above claims, **characterised in that** the arms (2a, 2b, 2c, 2d, ...) have different, in particular narrowing cross-sections.

9. Ultrasound transducer according to one of the above claims, **characterised in that** within an arm (2, a, b, c, d), in particular in the vicinity of the common connecting point (3), is arranged at least one cutout (13), in particular for oscillation disconnection in a spatial direction.

10. Method for ultrasound bonding, **characterised in that** an ultrasound transducer according to one of Claims 1 to 9 is used.

## Revendications

1. Transducteur ultrasonore (1) comportant au moins deux générateurs d'ultrasons (4), et un élément conducteur d'ultrasons, sur lequel peut être fixé un outil (6),
**caractérisé en ce que** l'élément conducteur d'ultrasons présente au moins trois bras (2a, 2b, 2c...) s'étendant à partir d'un point de jonction (3) commun, moyennant quoi un bras (2c) supportant l'outil (6) est orienté selon un angle de 180 degrés par rapport à un bras (2a, 2d) supportant un générateur d'ultrasons (4), et un ou plusieurs autres bras sont prévus, lesquels supportent un générateur d'ultrasons et chacun est orienté selon un angle de 90 degrés par rapport au bras qui supporte l'outil.

2. Transducteur ultrasonore selon l'une quelconque des revendications précédentes, **caractérisé en ce que**, sur au moins deux bras (2a, 2b) orientés selon un angle de 90 degrés et / ou 180 degrés l'un par rapport à l'autre, sont disposés des générateurs d'ultrasons, moyennant quoi le bras (2c) supportant l'outil (6) est orienté selon un angle de 90 degrés par rapport à ces bras (2a, 2b).

3. Transducteur ultrasonore selon l'une quelconque des revendications précédentes, **caractérisé en ce que** les bras avec les générateurs d'ultrasons, qui sont disposés dans un même plan, sont reliés les uns aux autres à l'aide d'un élément de fixation, sensiblement annulaire.

4. Transducteur ultrasonore selon l'une quelconque des revendications précédentes, **caractérisé en ce qu'**un bras (2d), qui est orienté selon un angle de 180 degrés par rapport au bras (2c) supportant l'outil (6), est un élément élastique (9), en particulier un élément de ressort, permettant notamment d'exercer une force de pression sur le transducteur ultrasonore (1), force qui permet de comprimer l'outil (6) sur une pièce d'oeuvre (7).

5. Transducteur ultrasonore selon l'une quelconque des revendications précédentes, **caractérisé en ce que** l'élément conducteur d'ultrasons, en particulier au moins un bras, présente un point de jonction permettant de fixer l'élément sur un appareil (8), en particulier un appareil permettant de réaliser des bondings.

6. Transducteur ultrasonore selon la revendication 5, **caractérisé en ce qu'**un point de jonction, dans l'état excité par les oscillations, se trouve à un noeud des oscillations.

7. Transducteur ultrasonore selon l'une quelconque des revendications précédentes, **caractérisé en ce qu'**au moins l'un des bras (2d) constitue le point de jonction pour établir la fixation sur un appareil.

8. Transducteur ultrasonore selon l'une quelconque des revendications précédentes, **caractérisé en ce que** les bras (2a, 2b, 2c, 2d...) présentent différentes sections, en particulier des sections qui se rétrécissent.

9. Transducteur ultrasonore selon l'une quelconque des revendications précédentes, **caractérisé en ce que**, à l'intérieur d'un bras (2a, b, c, d), en particulier aux environs du point de jonction (3) commun, est ménagé au moins un évidement (13), en particulier pour permettre la neutralisation des oscillations dans une direction spatiale.

10. Procédé de bonding par ultrasons, **caractérisé en ce qu'**on utilise un transducteur ultrasonore selon l'une quelconque des revendications 1 à 9.
